# EUROPEAN PATENT APPLICATION

(11) **EP 4 726 995 A1**
(43) Date of publication of application: **15.04.2026**
(21) Application number: 24206084.6
(22) Date of filing: 11.10.2024
(51) Int. Cl.: H02M 7/483, H02M 7/00, H05K 7/14, H01L 25/11

(54) **CONVERTER MODULE ARRANGEMENT AND MODULAR MULTILEVEL CONVERTER (MMC)**

(71) Applicant: Maschinenfabrik Reinhausen GmbH, 93059 Regensburg (DE)
(72) Inventor: Schulschenko, Aleksej, 93059 Regensburg (DE); Gercek, Cem Özgür, 93098 Mintraching (DE)

(57) **Abstract**

The present invention relates to a converter module arrangement (1) for the use in a Modular Multilevel Converter (MMC (3)) comprising a plurality of independent converter modules (11) that are connected in series and configured to convert an input voltage of the converter module arrangement (1) to an output voltage of the converter module arrangement (1), wherein a first subset of the plurality of converter modules (11) are connected in series and arranged in a first plane (25) and one behind the other along a first orientation to form a first converter module group (27), wherein a second subset of the plurality of converter modules (11) are connected in series and arranged in a second plane (29) which is parallel to the first plane (25) and comprises a distance to the first plane (25), wherein the converter modules (11) of the second subset are arranged one behind the other along a second orientation which is parallel to the first orientation to form a second converter module group (31), wherein the first converter module group (27) and the second converter module group (31) are connected in series, wherein at least one converter module (11) of the first converter module group (27) and at least one converter module (11) of the second converter module group (31) are arranged in a third plane (33) that is perpendicular to the first plane (25) and the second plane (29) and arranged in a third orientation that is perpendicular to the first and second orientation, and wherein a voltage difference between at least two of the converter module groups (27, 31, 37) is lower than a voltage difference between the input voltage and the output voltage of the converter module arrangement (1). The invention further relates to a Modular Multilevel Converter (MMC (3)) comprising at least three herein described converter arrangements (1) wherein each of the at least three converter arrangements (1) form a part of different legs (5, 7, 9) of the MMC (3).

## Description

The invention relates to a converter module arrangement for the use in a Modular Multilevel Converter (MMC) and a Modular Multilevel Converter (MMC). In other words, this describes a converter module arrangement for a Modular Multilevel Converter (MMC).

A Modular Multilevel Converter (MMC) is a power electronic device that can be utilized for high voltage direct current (HVDC) transmission systems and/or other applications that require the conversion of electrical power between different voltage levels. An MMC comprises a series of submodules, each of which comprises at least one capacitor and at least one switching unit that can be turned on and off to control the voltage output of the submodules and/or the MMC.

The output voltage of an MMC is usually controlled by adjusting the modulation index of the switching units in each submodule or at least in some of the submodules. The number of submodules and/or the voltage rating of the components can determine the range of voltage levels the MMC is able to convert. The MMC is usually capable of converting a (wide) range of (different) voltage levels, in particular from a few hundred volts to several kilovolts, making it a device particularly suitable for various power applications.

MMCs can provide the advantages of their scalability and customization. The number of submodules can be increased or decreased to accommodate different power requirements, like different voltage output levels. To maintain an advantageously high and/or specific performance, an MMC is typically controlled by a (sophisticated) control system that monitors the voltage, current, and/or temperature of the system. The control system can adjust the gating signals of the switches inside the submodules, in particular to maintain an advantageously high and/or specific performance.

Typically, MMCs are used in three-phase AC (alternating current) systems. In these systems, the MMC typically comprises or consists of three legs, each of which can be (specifically) isolated to prevent electrical interference and/or ensure safe operation.

The level of isolation between the submodules within the MMC can depend on the voltage difference between adjacent submodules. In conventional MMC designs, the submodules of each leg are arranged horizontally in a row to form a leg and the rows are stacked vertically to form the three legs of the converter. In this arrangement, isolation is provided not only between submodules within the same leg but also between the legs themselves, as the voltage differences between legs can be significant. The voltage differences can be the converter line-to-line output voltage..

One major drawback of conventional MMCs is that the required isolation distance between the legs, due to high voltage differences, can result in a taller overall design. Additionally, MMCs are typically housed in enclosures such as shipping containers, which have limited height. As a result, ensuring proper isolation between the legs can further increase the height of the MMC. At the same time the legs require sufficient isolation distance between the legs and the container. This makes the height of both the MMC and the enclosure a limiting factor in the design and manufacturing process.

Therefore, it is an object of the invention to provide a converter arrangement for the use in an MMC which can overcome one or more of the disadvantages of the prior art. In particular, it is an object of the invention to provide a converter arrangement for the use in an MMC that can reduce the overall height of the MMC, ideally while maintaining appropriate isolation distances between the legs and/or between the legs and the enclosure. It is a further object of the invention to provide a converter arrangement that can easily be enlarged, ideally without increasing the height of the MMC.

According to a first aspect of the present invention, the object is solved by a converter arrangement comprising the features of claim 1. Therefore, a converter arrangement for the use in a Modular Multilevel Converter (MMC) is provided, that comprises a plurality of independent converter modules that are connected in series and configured to convert an input voltage of the converter module arrangement to an output voltage of the converter module arrangement. A first subset of the plurality of converter modules, preferably at least two converter modules, are connected in series and arranged in a first plane and one behind the other along a first orientation to form a first converter module group. A second subset of the plurality of converter modules, preferably at least two converter modules, are connected in series and arranged in a second plane which is parallel to the first plane and comprises a distance to the first plane, wherein the converter modules of the second subset are arranged one behind the other along a second orientation which is parallel to the first orientation to form a second converter module group. The first converter module group and the second converter module group are connected in series. At least one converter module of the first converter module group and at least one converter module of the second converter module group are arranged in a third plane that is perpendicular to the first plane and the second plane and arranged in a third orientation that is perpendicular to the first and second orientation. A voltage difference between at least two of the converter module groups is lower than a voltage difference between the input voltage and the output voltage of the converter module arrangement.

The MMC can for example be used in HVDC systems preferably with Double Star Chopper Cells and/or with Double Star Bridge Cells and/or in Battery Energy Storage Systems. The Battery Energy Storage Systems can be connected to the DC side of the converter modules of the MMC, in parallel with capacitors of the converter modules. The MMC can be operated as both a rectifier and an inverter at the same time.

The converter arrangement comprises the plurality of independent converter modules that are connected in series and configured to convert an input voltage of the converter module arrangement to an output voltage of the converter module arrangement. Independent converter modules can comprise an electronic component that is designed to convert an input voltage to an output voltage. It can operate independently of other converter modules and can be connected in series with other modules to form a converter arrangement. Each independent converter module might comprise its own control circuitry, which allows it to adjust its output voltage based on the input voltage and/or load conditions. This can allow for more precise regulation of the output voltage and can improve the overall efficiency of the converter arrangement. Additionally, the use of independent converter modules can further allow for better fault tolerance, as a failure in one module will not necessarily affect the operation of the entire system.

The first subset and the second subset of the plurality of converter modules, preferably at least two converter modules, are connected in series. The series connection can comprise a direct series connection, in which case there may be a direct connection between the converter modules without other converter modules in between or an indirect series connection, in which case the two converter modules may be connected in series with at least one converter module in between the two converter modules. The indirect series connection can be understood as electrically in series without the need for the two converter modules to have a direct connection between them.

The converter modules of the first subset are arranged in the first plane and one behind the other along the first orientation to form the first converter module group. The first plane is preferably arranged such that the converter modules are arranged horizontally with respect to a ground on which the converter arrangement or the MMC is placed. Preferably, the converter modules of the first converter module group are arranged on the same plane. In other words, the converter modules of the first converter module group may form a row or column.

The second subset of the plurality of converter modules are arranged in the second plane which is parallel to the first plane and comprises a distance to the first plane, wherein the converter modules of the second subset are arranged one behind the other along the second orientation which is parallel to the first orientation to form a second converter module group. Preferably, the converter modules of the second converter module group are arranged on the same plane. In other words, the converter modules of the second converter module group can form a row or column that is parallel to the first converter module group. This means that the first converter module group and the second converter module group together can form two rows or two columns of the converter module arrangement.

The first converter module group and the second converter module group are connected in series. The series connection between the first and second module group can be a direct series connection with no other converter modules in between the groups or an indirect connection with other converter modules in between. Therefore, the first converter module group and the second converter module group form two rows or columns being connected in series, wherein each converter module group is arranged on a different plane.

The at least one converter module of the first converter module group and the at least one converter module of the second converter module group are arranged in the third plane that is perpendicular to the first plane and the second plane and arranged in the third orientation that is perpendicular to the first and second orientation. The third plane is preferably arranged such that the converter modules are arranged vertically with respect to the ground on which the converter arrangement or the MMC is placed. Preferably, the converter modules of the third converter module group are arranged on the same plane. In other words, the converter modules of the first converter module group can form a row or column, depending on the orientation of the first and second converter module group. If the first and second converter module group each form a row, the third converter module group then forms a column such that the first and second converter module groups are at least partially overlapping in a vertical direction.

A voltage difference between the at least two of the converter module groups is lower than a voltage difference between the input voltage and the output voltage of the converter module arrangement. As already mentioned, the converter modules of the first converter module group and the converter modules of the second converter module group are connected in series. In this configuration the voltage difference between the input voltage and the output voltage is present between the first converter module of the first converter module group and the second converter module of the second converter module group. As mentioned herein, the converter modules may require an isolation distance between each other and therefore also between the converter module groups. When the converter module groups are arranged in a row or column, the isolation distance depends on the highest voltage difference between two adjacent converter modules, meaning that if the converter arrangement comprises two rows being connected in series, the isolation distance between the rows depends on the highest voltage difference between two converter modules of each row. In the scenario where the converter arrangement comprises two rows being placed above or below each other, the voltage difference between the first and last converter module is the highest as this voltage difference may be the voltage difference between the input voltage and the output voltage. By providing a converter arrangement in which the voltage difference between the two converter module groups is lower than a voltage difference between the input voltage and the output voltage of the converter module arrangement it can be achieved that the two converter module groups can be placed closer together as the lower voltage difference may require a lower isolation distance between the converter module groups. This means that the herein described converter module arrangement may provide a lower height as the converter module groups may require less isolation distance in a vertical direction between the converter modules, leading to an MMC with reduced height requirement.

Further, the converter arrangement can be easily enlarged by connecting another converter arrangement in series. This provides the benefit that the enlarged converter arrangement does not need to rearrange the converter modules, especially not in the third plane, the vertical plane, because the converter module groups may not need a higher isolation distance in between the converter module groups, if another converter arrangement is connected in series. Compared to a converter arrangement of conventional MMCs, in which the converter module rows, the legs of the MMC, are arranged vertically above or below each other, enlarging a leg of the MMC may done by connecting more converter modules in series and arranging them horizontally in the same row of the leg. This may result in a higher voltage difference between the legs (and the rows), which may require a higher isolation distance between the rows and therefore a higher vertical height of the MMC. As already mentioned, the height of the MMC can be a limiting factor, such that with the herein described converter arrangement an MMC can be provided that can easily be enlarged if needed, without the need of changing the vertical arrangement and height of the converter arrangement.

In summary, a converter arrangement for the use in an MMC is provided that reduces the overall height of the MMC while maintaining appropriate isolation distances between the legs and between the legs and the enclosure. Further, the described converter arrangement can easily be enlarged without compromising the height of the MMC.

According to a preferred embodiment, the converter module arrangement comprises an isolation distance between at least two directly adjacent converter module groups, that is less than an overall isolation distance between the input voltage and the output voltage of the converter module arrangement. The isolation distance can be understood as a clearance distance that refers to the minimum distance that should be maintained between two conductive parts, in this case two converter modules, to prevent electrical arcing or breakdown. The overall isolation distance can be defined by the isolation distance that is recommended or required between the converter module that is connected to the input voltage and the converter module that provides the output voltage of the converter arrangement. The overall isolation distance can also be the isolation distance that is recommended or required between two converter module arrangements. This may be the case if one converter module arrangement is used as a leg of an MMC and placed adjacent to another converter module arrangement that is used as another leg of the MMC. In this case the overall isolation distance can also comprise the isolation distance recommended or required to isolate the one converter arrangement from the other converter module arrangement.

Compared to the converter arrangement known from the art, this provides the benefit that the converter module arrangements and therefore each leg of an MMC can be placed horizontally one after the other instead of placing the legs of the MMC above or below each other which may require an increased vertical isolation distance between the legs, such that the converter arrangements may provide a lower height.

According to a preferred embodiment, a third subset of the plurality of converter modules are connected in series and arranged in a fourth plane and one behind the other along a fourth orientation, preferably horizontally, to form a third converter module group, wherein the fourth plane is parallel to the first plane and the second plane and perpendicular to the third plane and the fourth orientation is parallel to the first orientation and the second orientation and perpendicular to the third orientation, wherein the third converter module group is connected in series to the first converter module group or the second converter module group, wherein at least one converter module of the third converter module group is arranged in the third plane and in the third orientation. In this embodiment, the converter module groups, meaning the first converter module group, the second converter module group and the third converter module group together may form three rows or three columns of the converter module arrangement, wherein at least one converter module of each row or column may be arranged perpendicular to the rows or columns. The converter arrangement with three rows allows an arrangement that is comparable to the arrangement in conventional MMCs, preferably with a lower height, due to the lower voltage difference between the rows. This is achieved in such a way that a first group of the converter module groups receives the input voltage, a second group of the converter module groups provides the output voltage, and a third converter module group is arranged vertically between the first and second converter module groups. With this arrangement it can be achieved that the isolation distance between the converter module groups can be lower compared to the isolation distance between the rows of a converter arrangement in a conventional MMC as the voltage difference between one converter module group to another converter module group may be less than the difference between the input voltage and the output voltage, which in the conventional MMC usually is the phase-to-phase or leg-to-leg voltage.

According to a preferred embodiment, the converter module arrangement further comprises a rack for receiving the plurality of converter modules, wherein the rack comprises three rows for receiving the converter module groups. The rack can comprise a structure that is designed to securely hold the converter modules in place. Preferably, the rack may further comprise spacers that act as distance spacers to ensure that the rack comprises sufficient isolation distance to other racks or to an enclosure, like a container, in which the rack may be placed to form a part of a leg of an MMC. The spacers may not only support that the rack provides sufficient isolation distance to other racks or the enclosure, but they can also act as feet of the rack. The three rows of the rack may be arranged such that they comprise sufficient isolation distance between the rows and efficient cooling of the converter modules. In addition, the rack may include various features such as fans, filters, or other cooling mechanisms to ensure that the converter modules operate within their specified temperature range. The use of a (dedicated) rack for the converter arrangement may provide the advantage that the converter modules can be easily installed and used as a leg of an MMC. This may also provide the benefit that the converter arrangement can be easily tested independently from other legs or converter arrangements of the MMC.

According to a preferred embodiment, the rows comprise an isolation distance, preferably a clearance distance, to each other to achieve an electrical isolation between the converter module groups, wherein the isolation distance is less than 70 mm, preferably less than 50 mm. Preferably, the isolation distance is a fraction of the isolation distance that may be required to isolate the input voltage from the output voltage between the converter modules of the converter arrangement. Further preferably, the isolation distance is a fraction of the isolation distance that may be required to isolate two rows of an MMC in which each converter module of each row is arranged horizontally. With this isolation distance the converter arrangement can comprise a lower height, such that the converter arrangement can be arranged in a conventional container or enclosure even if the converter arrangement provides a high output voltage.

According to a preferred embodiment, the rack comprises a height of less than 2600 mm, preferably less than 2570 mm, further preferably less than 2550 mm. Preferably, the height of the rack is less than the height of a conventional rack of a conventional MMC. In a conventional MMC comprising three rows, each row dedicated to a phase or leg of the MMC, the height of the conventional rack used in the conventional MMC may be determined by the height of each row plus the (vertical) isolation distance between the rows. The herein described height of the rack of less than 2600 mm is less than the height of a conventional rack, as the isolation distance between the rows is lower. This results in a converter arrangement and an MMC with a decreased height therefore providing sufficient space in an enclosure or a container in which the converter arrangements may be placed to form a part of a leg of the MMC.

According to a preferred embodiment, the converter module arrangement further comprises a packing density of more than 30 submodules per m³. A conventional known converter arrangement comprising 12 converter modules use approx. 0,406 m³ of space. This results in approx. 29,56 converter modules per cubic meter (m³). The herein described converter arrangement uses less vertical space such that it uses approx. 0,393 m³ for the same 12 converter modules. This results in approx. 30,53 converter modules per cubic meter. Hence, the conventional converter arrangement comprises a higher packing density compared to the conventional converter arrangement. It has to be noted that these calculations shall uncover the difference between the herein described converter arrangement and conventional converter arrangements that comprise solely horizontally arranged converter modules per leg needing more vertical space between the rows.

According to a preferred embodiment, the converter module groups are arranged vertically above or below each other, such that the converter modules of one converter module group are arranged vertically above or below the converter modules of another converter module group, and wherein the converter module groups are connected in series in an alternating manner. The alternating manner shall be understood in such a way that the converter module groups are connected only on one side to another group and that if a first converter group is connected in series to a second converter group on one side, then the second converter group is connected to a third converter group on an opposing side. With this connection structure the converter modules are connected in series in a serpentine configuration. This offers the benefit that the voltage difference between each converter module of one converter module group to an adjacent converter module of a different converter module group may be a fraction of the voltage difference between the input voltage and the output voltage, which may lead to a smaller isolation distance requirement between the two converter module groups.

According to a preferred embodiment, the converter module groups are arranged vertically above or below each other, such that the converter modules of one converter module group are arranged vertically above or below the converter modules of another converter module group, and wherein the converter module groups are connected in series on opposite ends of the converter module groups in an alternating manner. With the vertically arrangement of the converter module groups each group can be seen as a row of the converter arrangement. In this arrangement a first (top) row is connected to a second row on a first end of the first row and the second row is connected to a third row on an end of the second row that is opposite of the first end of the first row. In other words, the converter modules are connected in a Z-connection configuration where the top left converter module may receive the input voltage and the bottom right converter module may output the output voltage. This Z-connection configuration may provide the benefit contrary to the state of the art, that it can entail less (vertical) isolation distance between the rows and it can easily be enlargeable by placing another converter arrangement horizontally and connecting is in series, wherein no further (vertical) isolation distance may be required between the rows.

According to a preferred embodiment, one of the converter modules of the first converter module group is directly connected in series to a directly adjacent converter module of the second converter module group. A direct connection can include a connection without any further converter arrangement, for example of another group, in between the first converter module group and the second converter module group. In this arrangement a converter module group is directly connected to an adjacent converter module group. This means that there is no other converter module of another converter module group in between. In this embodiment the converter arrangement can form a Z-connection configuration or a NN- or M-connection configuration. The M-connection configuration can be achieved if the converter module groups each represent a column of the converter arrangement and the converter module groups are connected in series to another adjacent converter module group on one side, top or bottom, of the columns. In the NN- or M-connection configuration the isolation distance between two vertically arranged converter modules can be lower as two vertically arranged converter modules only comprise a small voltage difference.

According to a preferred embodiment, one of the converter modules of the first converter module group is directly connected in series to a converter module of the second converter module group that is arranged on an opposite end of the first converter module group. A direct connection can include a connection without any further converter arrangement, for example of another group, in between the first converter module group and the second converter module group. By connecting two converter modules of two converter module groups that are arranged on opposite ends of the converter module groups, a Z- or NN-connection configuration can be realized. In an exemplary embodiment a converter arrangement may comprise 12 converter modules being arranged in such a way that the converter arrangement comprises three rows and four columns. In each column the converter modules are arranged vertically above or below each other and connected in series to an adjacent vertically arranged converter module. To achieve the NN-connection configuration each converter module of the first row may be connected to a converter module of the third row of a next column. This arrangement may provide a low required (vertical) isolation distance between each row and a low required (horizontal) isolation distance between each column that may lead to an improved height and length of the converter arrangement and therefore also of the MMC.

According to a second aspect of the present invention, the object is solved by a Modular Multilevel Converter (MMC) comprising the features of claim 12, Therefore, an MMC is provided that comprises at least three converter arrangements as described herein, wherein each of the at least three converter arrangements form a part of different legs of the MMC.

The MMC comprises a first herein described converter arrangement that forms a part of a first leg or phase of the MMC, a second herein described converter arrangement that forms a part of a second leg or phase of the MMC, and a third herein described converter arrangement that forms a part of a third leg or phase of the MMC. The MMC can also have 6 converter arrangements formed by 6 legs or phases of the MMC. Compared to a conventional MMC in which each leg or phase comprises converter modules arranged horizontally in one plane and each leg or phase being arranged in parallel to another phase or leg, the conventional phases or legs may require a higher isolation distance between the legs. This is because the voltage difference between the legs can usually be as high as the phase-to-phase voltage meaning the voltage difference between the input voltage and the output voltage of each phase.

According to a preferred embodiment, the MMC further comprises a container that is adapted to receive the at least three converter arrangements, wherein the at least three converter arrangements are arranged one after the other on a common, preferably horizontal, plane in the container. Preferably, the container is a conventional shipping container. A conventional shipping container (ISO-container) comprises fixed dimensions with a height of approximately 2591 mm, a width of approximately 2428 mm a length of approximately 6058 mm (20 feet) or 12192 mm (40 feet). Therefore, the height of the shipping container may be a limiting factor wherein the container provides sufficient length to accommodate a converter arrangement with three legs to form a three phase MMC. Due to the length of the container the converter arrangements can be placed horizontally one after the other to form the three phase MMC.

Each of the converter arrangements preferably comprises a rack such that the converter arrangements can be placed independently in the container. As described before, the converter arrangement may allow a lower height due to the lower required or recommended isolation distance between the rows. This may not only allow an easier placement within the container but also a higher (vertical) isolation distance between the converter arrangements and the container.

According to a preferred embodiment, the at least three converter arrangements are connected in a Delta connection or in a Y-connection. In the Delta connection, a positive terminal of a first converter arrangement is connected to a negative terminal of a second converter arrangement, a positive terminal of the second converter arrangement is connected to a negative terminal of a third converter arrangement, and a positive terminal of the third converter arrangement is connected to the negative terminal of the first converter arrangement. The Delta connection can provide the advantage of higher power transmission capability due to the absence of a neutral point. In the Y-connection, the positive terminals of all three converter arrangements are connected together at a common (neutral) point. The Y-connection can provide the advantage of providing a neutral point, which is useful for powering single-phase loads and for measuring voltages.

According to a preferred embodiment, the MMC further comprises a plurality of converter arrangements, wherein each leg of the MMC comprises at least two converter arrangements of the plurality of converter arrangements connected in series. With the two converter arrangements, the MMC may provide a higher output voltage. Due to the vertical arrangement of the converter arrangements the converter modules may not need to comprise a higher voltage isolation and therefore the converter arrangements can be taken without the need to change its height. Therefore, the same converter arrangements and the same container can be used even if the MMC may provide a higher output voltage by connecting two converter arrangements in series to form a leg of the MMC.

In summary, an MMC and a converter arrangement is provided that improve the design and manufacturing process of MMCs and provide a more efficient and effective solution for high voltage power conversion in three-phase AC systems. This will be achieved by an alternative arrangement of converter modules within the MMC that may reduce the recommended isolation distance between the converter modules and may reduce the overall height of the converter arrangement and the MMC. This may also allow for greater flexibility in the design and placement of MMCs in various applications and environments. Additionally, this converter arrangement may allow for an easier testing and shipping of each phase of an MMC as each phase provides a converter arrangement that comprises a (own) rack that may have a higher converter module density and therefore lower dimensions.

Further features, advantages and application possibilities of the present invention may be derived from the following description of exemplary embodiments and/or the figures. Thereby, all described and/or visually depicted features for themselves and/or in any combination may form an advantageous subject matter and/or features of the present invention independent of the combination in the individual claims or the dependencies. Furthermore, in the figures, same reference signs may indicate same or similar objects.
- Fig. 1: schematically illustrates a circuit diagram of a converter arrangement of an MMC,
- Fig. 2: schematically illustrates a converter arrangement of a conventional MMC,
- Fig. 3 to 5: schematically illustrate different embodiments of a herein described converter arrangement, and
- Fig. 6: schematically illustrates an embodiment of a herein described MMC.

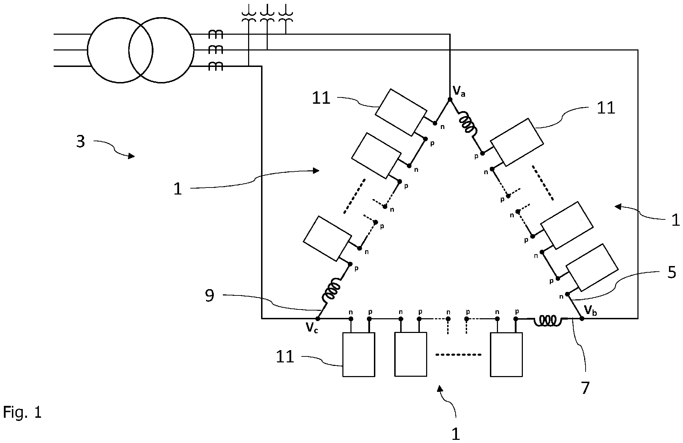

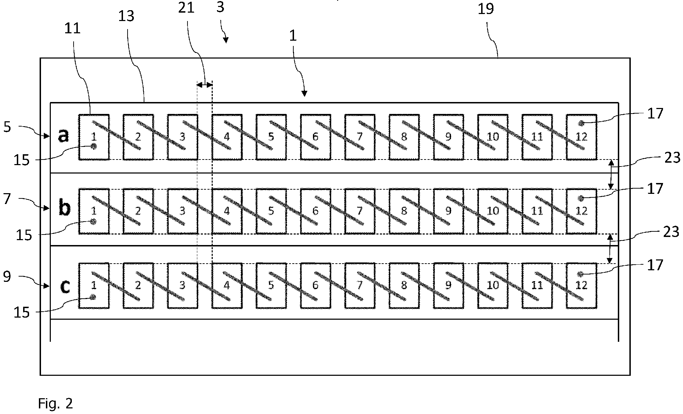

Fig. 1 schematically illustrates a circuit diagram of a converter arrangement 1 of an MMC 3. The MMC 3 is connected to three phases and comprises a first leg 5, a second leg 7 and a third leg 9 being connected in a Delta-connection. Each one of the legs 5, 7, 9 comprises a plurality of independent converter modules 11 that are connected in series. In Fig. 1 the converter modules 11 are arranged in one row one after the other, so that the converter arrangement 1 and the MMC 3 shown in Fig .1 comprises a conventional MMC 3. The conventional MMC 3 will be described further with respect to Fig. 2.

Fig. 2 schematically illustrates a converter arrangement 1 of a conventional MMC 3. The MMC 3 comprises the first leg 5 that is denoted by the letter a, the second leg 7 that is denoted by the letter b, and the third leg 9 that is denoted by the letter c. Each one of the three legs 5, 7, 9 comprises 12 converter modules 11, denoted by numbers 1 to 12. The 12 converter modules 11 of each leg 5, 7, 9 are arranged horizontally in the same plane such that each leg 5, 7, 9 forms a row. The MMC 3 further comprises a rack 13 for receiving the converter modules 11. The rack 13 is configured to receive each converter module 11 of each leg 5, 7, 9 thereby comprising 36 slots. Each leg 5, 7, 9 comprises an input 15 for receiving an input voltage and an output 17 for providing an output voltage. The MMC 3 further comprises a container 19 that acts as an enclosure for the MMC 3.

As can be seen from Fig. 2, the converter modules 11 within each leg are arranged horizontally one after the other such that the voltage difference between the converter modules 11 is relatively low. The converter modules 11 of each row comprise a first horizontal distance 21 which can be denoted as the horizontal isolation distance. The isolation distance can be understood as a clearance distance that refers to the minimum distance that should or must be maintained between two conductive parts, in this case two converter modules 11, to prevent electrical arcing or breakdown. Due to the relatively low voltage difference between the converter modules 11 the first horizontal distance 21 can be relatively low. The horizontal distance 21 can be the same between each converter module 11 of each leg 5, 7, 9 as the converter modules 11 can comprise the same voltage difference from one to the other.

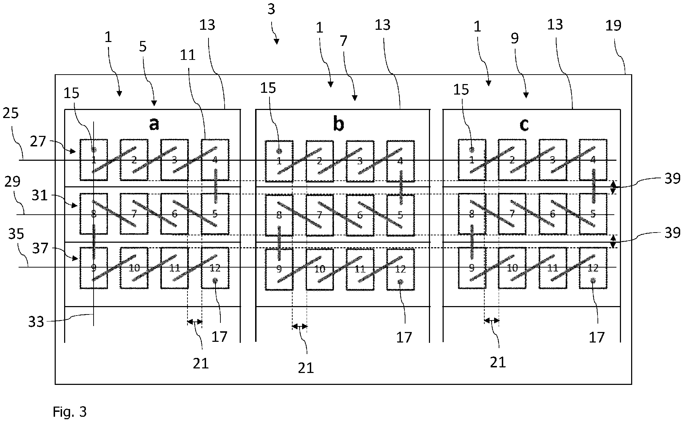

The legs 5, 7, 9 of the MMC 3 comprise a first vertical distance 23 to each other which can be denoted as the vertical isolation distance. With the arrangement shown in Fig. 2, the first vertical distance 23 should be relatively high as the legs 5, 7, 9 can comprise a voltage difference to each other that comprises a phase-to-phase voltage. A herein described converter module arrangement 1 will be described with respect to Figures 3 to 5, wherein each Figure shows an embodiment of a herein described converter arrangement.

Figures 3 to 5 schematically illustrate different embodiments of a herein described converter arrangement 1. The converter arrangement 1 comprises a plurality of independent converter modules 11 that are connected in series and configured to convert an input voltage at the input 15 to an output voltage provided at the output 17. The converter module arrangement 1 comprises a first subset of the plurality of converter modules 11 that are connected in series and arranged in a first plane 25 and one behind the other along a first orientation to form a first converter module group 27. A second subset of the plurality of converter modules 11 are connected in series and arranged in a second plane 29 which is parallel to the first plane 25 and comprises a distance to the first plane 25, wherein the converter modules 11 of the second subset are arranged one behind the other along a second orientation which is parallel to the first orientation to form a second converter module group 31. The first converter module group 27 and the second converter module group 31 are connected in series. At least one converter module 11 of the first converter module group 27 and at least one converter module 11 of the second converter module group 31 are arranged in a third plane 33 that is perpendicular to the first plane 25 and the second plane 29 and arranged in a third orientation that is perpendicular to the first and second orientation. A voltage difference between at least two of the converter module groups 27, 31 is lower than a voltage difference between the input voltage and the output voltage of the converter module arrangement 1.

Further, a third subset of the plurality of converter modules 11 are connected in series and arranged in a fourth plane 35 and one behind the other along a fourth orientation, preferably horizontally, to form a third converter module group 37, wherein the fourth plane 35 is parallel to the first plane 25 and the second plane 29 and perpendicular to the third plane 33 and the fourth orientation is parallel to the first orientation and the second orientation and perpendicular to the third orientation, wherein the third converter module group 37 is connected in series to the first converter module group 27 or the second converter module group 31, wherein at least one converter module 11 of the third converter module group 37 is arranged in the third plane 33 and in the third orientation.

The converter arrangement 1 of Fig. 3 comprises three legs 5, 7, 9, again denoted by the letters a, b, c. Each leg 5, 7, 9 comprises 12 converter modules 11 connected in series. Each converter module 11 of each leg 5, 7, 9 comprises the first horizontal distance 21 as the voltage difference between the horizontally arranged converter modules 11 is the same as in the conventional MMC 3 of Fig. 2. The converter arrangement 1 shown in Fig. 3 comprises a second vertical distance 39 which can be denoted as the vertical isolation distance. It can be seen that the second vertical distance 39 is lower than the first vertical distance 23 shown in Fig. 2. This is due to the fact that the vertically arranged converter modules 11 comprise a voltage difference to each other that is lower than the phase-to-phase voltage. In detail, the second vertical distance 39 between the first converter module group 27 and the second converter module group 31 depends on the highest voltage difference of two vertically arranged converter modules 11. In Fig. 3 the highest voltage difference is present between the 1^{st} and the 8^{th} and the 5^{th} and 12^{th} converter module 11 of the first leg 5. This voltage difference is lower than the phase-to-phase voltage, therefore, less isolation is required or recommended between the first converter module group 27 and the second converter module group 31 and between the second converter module group 31 and the third converter module group 37.

Another main difference between the conventional converter arrangement 1 of Fig. 2 and the herein described converter arrangement 1 of Figures 3 to 5 is that each leg 5, 7, 9 comprises an own dedicated rack 13 for receiving the plurality of converter modules 11. The rack 13 comprises three rows for receiving the converter module groups 27, 31, 37. The rack 13 provides the benefit that each leg 5, 7, 9 can be tested separately which makes it easier to manufacture and design the converter arrangements 1.

In Fig. 3 the first converter module group 27, the second converter module group 31 and the third converter module group 37 of the converter arrangement 1 represent a row of the converter arrangement 1, being connected in such a way that they comprise a serpentine configuration or connection. It can also be seen that the converter modules 11 are connected in a Z-connection. This means that the serially connected converter modules 11 form the letter Z. This will be achieved by arranging the converter module groups 27, 31, 37 vertically above or below each other, such that the converter modules 11 of the first converter module group 27 are arranged vertically above the converter modules 11 of the second converter module group 31 and the third converter module group 37. The converter module groups 27, 31, 37 are connected in series in an alternating manner. The alternating manner shall be understood in such a way that the converter module groups 27, 31, 37 are connected only on one side to another group. The first converter group 27 is connected in series to the second converter group 31 on one side (connection between 4^{th} and 5^{th} converter module 11) and the second converter group 31 is connected to the third converter group 37 on an opposing side (connection between 8^{th} and 9^{th} converter module 11). With this connection structure the converter modules 11 are connected in series in a serpentine configuration. This offers the benefit that the voltage difference between each converter module 11 of one converter module group to an adjacent converter module 11 of a different converter module group is always a fraction of the voltage difference between the input voltage and the output voltage, leading to a smaller isolation distance requirement or recommendation between the converter module groups 27, 31, 37.

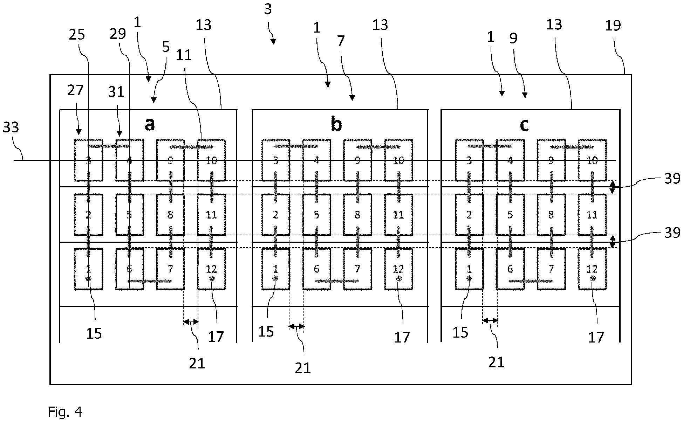

Fig. 4 schematically illustrates a further embodiment of a herein described converter arrangement 1. In this embodiment, the converter module groups 27, 31, 37 are arranged in columns instead of a row as shown in Fig. 3. Therefore, the first plane 25 and the second plane 29 are arranged vertically and the third plane 33 is arranged horizontally. One of the converter modules 11 of the first converter module group 27 is directly connected in series to a directly adjacent converter module 11 of the second converter module group 31. In this arrangement the first converter module group 27 is directly connected to the second converter module group 31 (connection between 3^{rd} and 4^{th} converter module 11). This means that there is no other converter module 11 of another converter module group in between. In this embodiment the converter arrangement 1 can form a M-connection. The M-connection can be achieved by providing four converter module groups each represent a column of the converter arrangement 1 and the converter module groups are connected in series to another adjacent converter module group on one side of the columns in an alternating manner (series connection between 3^{rd} and 4^{th} converter module 11, 6^{th} and 7^{th} converter module, and 9^{th} and 10^{th} converter module). In the M-connection the second vertical distance 39 (isolation distance between two vertically arranged converter modules 11) can be lower as two vertically arranged converter modules 11 only comprise a small voltage difference.

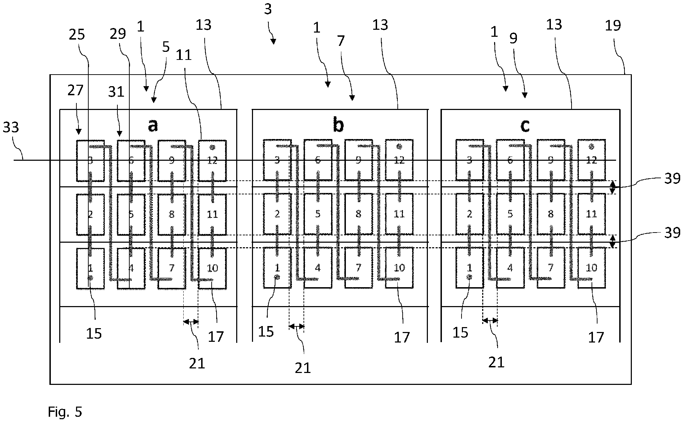

Fig. 5 schematically illustrates a further embodiment of a herein described converter arrangement. In this embodiment, the converter module groups 27, 31, 37 are also arranged in columns. In this embodiment the converter arrangement 1 can form a NN-connection. The NN-connection can be achieved by providing four converter module groups each represent a column of the converter arrangement 1. One of the converter modules 11 of the first converter module group 27 is directly connected in series to a converter module 11 of the second converter module group 31 that is arranged on an opposite end of the one converter module 11 of first converter module group 27. By connecting two converter modules 11 of two converter module groups that are arranged on opposite ends of the converter module groups (connection between 3^{rd} and 4^{th} converter module 11, 6^{th} and 7^{th} converter module 11, and 9^{th} and 10^{th} converter module 11), the NN-connection configuration can be realized. This arrangement may provide a low required (vertical) isolation distance between each row and a low required (horizontal) isolation distance between each column leading to an improved height and length of the converter arrangement 1 and therefore also of the MMC 3.

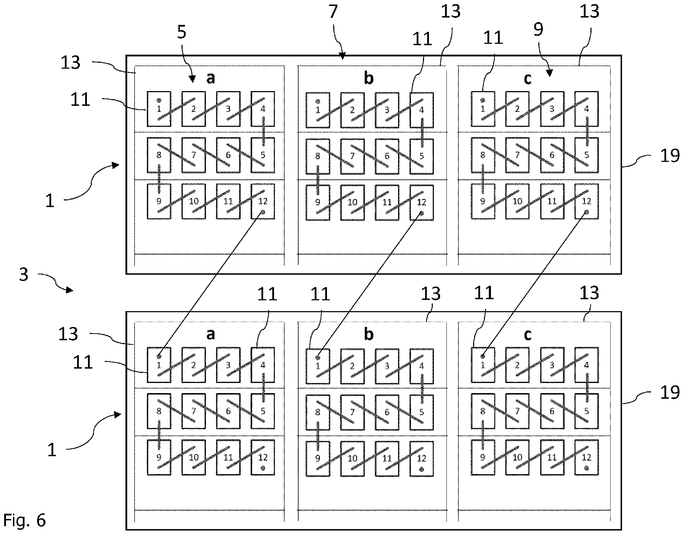

Fig. 6 schematically illustrates an embodiment of a herein described MMC 3. The MMC 3 comprises six converter arrangements 1 as described herein, wherein three of the six converter arrangements 1 are arranged horizontally in a container 19 and each one of the three converter arrangements 1 is connected in series to another converter arrangement 1 of another container 19 to form a leg 5, 7, 9 of the MMC 3. Fig. 6 shows the scenario where the MMC 3 comprises a plurality of converter arrangements 1, wherein each leg 5, 7, 9 of the MMC 3 comprises at least two converter arrangements 1 of the plurality of converter arrangements 1 connected in series. With the two converter arrangements 1, the MMC 3 can provide a higher output voltage. Due to the vertical arrangement of the converter arrangements 1 the converter modules 11 do not need to comprise a higher voltage isolation and therefore the converter arrangements 1 can be taken without the need to change its height. Therefore, the same converter arrangements 1 and the same container 19 can be used even if the MMC 3 needs to provide a higher output voltage by connecting two converter arrangements 1 in series to form a leg 5, 7, 9 of the MMC 3.

In summary, a converter arrangement 1 for the use in an MMC 3 is provided that reduces the overall height of the MMC 3 while maintaining appropriate isolation distances between the legs 5, 7, 9 and between the legs 5, 7, 9 and the container 19. Further, the described converter arrangement 1 can easily be enlarged without compromising the height of the MMC 3.

### Reference signs

- 1: Converter arrangement
- 3: MMC
- 5: first leg
- 7: second leg
- 9: third leg
- 11: Converter modules
- 13: Rack
- 15: Input
- 17: Output
- 19: Container
- 21: first horizontal distance
- 23: first vertical distance
- 25: first plane
- 27: first converter module group
- 29: second plane
- 31: second converter module group
- 33: third plane
- 35: fourth plane
- 37: third converter module group
- 39: second vertical distance

## Claims

1. A converter module arrangement (1) for the use in a Modular Multilevel Converter (MMC (3)) comprising
a plurality of independent converter modules (11) that are connected in series and configured to convert an input voltage of the converter module arrangement (1) to an output voltage of the converter module arrangement (1),
wherein a first subset of the plurality of converter modules (11) are connected in series and arranged in a first plane (25) and one behind the other along a first orientation to form a first converter module group (27),
wherein a second subset of the plurality of converter modules (11) are connected in series and arranged in a second plane (29) which is parallel to the first plane (25) and comprises a distance to the first plane (25), wherein the converter modules (11) of the second subset are arranged one behind the other along a second orientation which is parallel to the first orientation to form a second converter module group (31),
wherein the first converter module group (27) and the second converter module group (31) are connected in series,
wherein at least one converter module (11) of the first converter module group (27) and at least one converter module (11) of the second converter module group (31) are arranged in a third plane (33) that is perpendicular to the first plane (25) and the second plane (29) and arranged in a third orientation that is perpendicular to the first and second orientation, and
wherein a voltage difference between at least two of the converter module groups (27, 31, 37) is lower than a voltage difference between the input voltage and the output voltage of the converter module arrangement (1).

2. The converter module arrangement (1) according to claim 1, wherein the converter module arrangement (1) comprises an isolation distance between at least two directly adjacent converter module groups (27, 31, 37), that is less than an overall isolation distance between the input voltage and the output voltage of the converter module arrangement (1).

3. The converter module arrangement (1) according to claim 1 or 2,
wherein a third subset of the plurality of converter modules (11) are connected in series and arranged in a fourth plane (35) and one behind the other along a fourth orientation to form a third converter module group (37), wherein the fourth plane (35) is parallel to the first plane (25) and the second plane (29) and perpendicular to the third plane (33) and the fourth orientation is parallel to the first orientation and the second orientation and perpendicular to the third orientation,
wherein the third converter module group (37) is connected in series to the first converter module group (27) or the second converter module group (31),
wherein at least one converter module (11) of the third converter module group (37) is arranged in the third plane (33) and in the third orientation.

4. The converter module arrangement (1) according to one of the preceding claims, further comprising
a rack (13) for receiving the plurality of converter modules (11), wherein the rack (13) comprises three rows for receiving the converter module groups (27, 31, 37).

5. The converter module arrangement (1) according to claim 4, wherein the rows comprise an isolation distance to each other to achieve an electrical isolation between the converter module groups (27, 31, 37), wherein the isolation distance is less than 70 mm, preferably less than 50 mm.

6. The converter module arrangement (1) according to claim 4 or 5, wherein the rack (13) comprises a height of less than 2600 mm, preferably less than 2570 mm, further preferably less than 2550 mm.

7. The converter module arrangement (1) according to any one of the preceding claims, further comprising a packing density of more than 30 submodules per m3.

8. The converter module arrangement (1) according to one of the preceding claims, wherein the converter module groups (27, 31, 37) are arranged vertically above or below each other, such that the converter modules (11) of one converter module group (27, 31, 37) are arranged vertically above or below the converter modules (11) of another converter module group (27, 31, 37), and wherein the converter module groups (27, 31, 37) are connected in series in an alternating manner.

9. The converter module arrangement (1) according to one of the preceding claims, wherein the converter module groups (27, 31, 37) are arranged vertically above or below each other, such that the converter modules (11) of one converter module group (27, 31, 37) are arranged vertically above or below the converter modules (11) of another converter module group (27, 31, 37), and wherein the converter module groups (27, 31, 37) are connected in series on opposite ends of the converter module groups (27, 31, 37) in an alternating manner.

10. The converter module arrangement (1) according to one of the preceding claims, wherein one of the converter modules (11) of the first converter module group (27) is directly connected in series to a directly adjacent converter module (11) of the second converter module group (31).

11. The converter module arrangement (1) according to one of the claims 1 to 9, wherein one of the converter modules (11) of the first converter module group (27) is directly connected in series to a converter module (11) of the second converter module group (31) that is arranged on an opposite end of the first converter module group (27).

12. A Modular Multilevel Converter (MMC (3)) comprising at least three converter arrangements (1) according to any one of the preceding claims, wherein each of the at least three converter arrangements (1) form a part of different legs (5, 7, 9) of the MMC (3).

13. The Modular Multilevel Converter according to claim 12, further comprising a container (19) that is adapted to receive the at least three converter arrangements (1), wherein the at least three converter arrangements (1) are arranged one after the other on a common plane in the container (19).

14. The Modular Multilevel Converter according to claims 12 or 13, wherein the at least three converter arrangements (1) are connected in a Delta connection or in a Y-connection.

15. The Modular Multilevel Converter according to any one of claims 12 to 14, further comprising a plurality of converter arrangements (1), wherein each leg (5, 7, 9) of the MMC (3) comprises at least two converter arrangements (1) of the plurality of converter arrangements (1) connected in series.
